# EUROPEAN PATENT APPLICATION

(11) **EP 2 320 461 A2**
(43) Date of publication of application: **11.05.2011**
(21) Application number: 09762660.0
(22) Date of filing: 10.06.2009
(51) Int. Cl.: H01L 27/146

(54) **METHOD FOR MANUFACTURING CMOS IMAGE SENSOR**

(30) Priority: 11.06.2008 KR 20080054877
(71) Applicant: Crosstek Capital, LLC, Wilmington, DE 19808 (US)
(72) Inventor: PYO, Sung-Gyu, Yongin-si Gyeonggi-do 448-756 (KR)
(74) Representative: Kazi, Ilya
(86) International application number: PCT/KR2009/003112
(87) International publication number: WO 2009/151273

(57) **Abstract**

Disclosed is a method of manufacturing a CMOS image sensor, capable of preventing hillock-type defects caused by the delamination of interconnections from occurring in the CMOS image sensor. The method of manufacturing the CMOS image sensor includes preparing a substrate having a first metal interconnection, forming an interlayer insulation layer over the first metal interconnection, forming a contact hole to expose a part of the first metal interconnection by etching the interlayer insulation layer, forming a buffer layer on the interlayer insulation layer along an inner surface of the contact hole, performing an annealing process, forming a spacer on an inner sidewall of the contact hole by etching the buffer layer, forming a barrier metal layer along a top surface of the interlayer insulation layer including the spacer, forming a contact plug on the barrier metal layer such that the contact hole is filled with the contact plug, and forming a second metal interconnection on the interlayer insulation layer such that the second metal interconnection makes contact with the contact plug.

## Description

### Technical Field

The present invention relates to a semiconductor manufacturing technology, and more particularly to a method of forming a contact plug for manufacturing a CMOS image sensor including a metal interconnection having a multilayer structure.

### Background Art

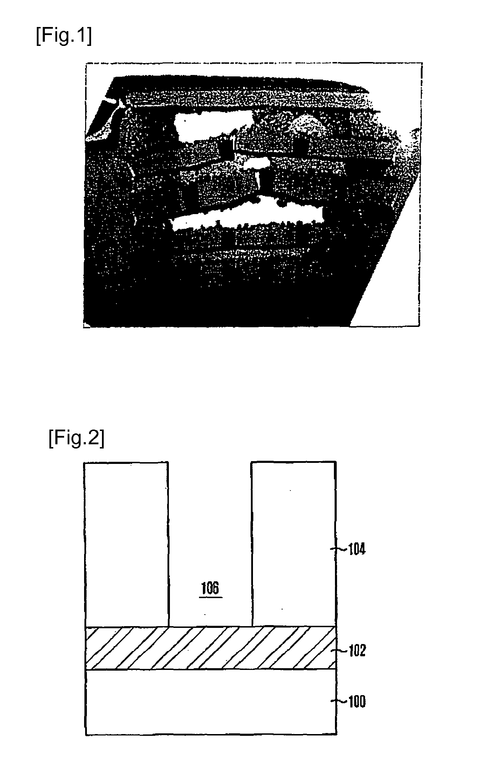

In a method of manufacturing a CMOS image sensor, a high-temperature heat treatment is performed after depositing a passivation layer in order to improve a dark characteristic. However, as shown in FIG. 1, interconnection delamination may occur due to the high-temperature heat treatment, so that the product yield of a device may be reduced and the device may become defective. This is because the heat treatment is performed at the high temperature for a long time after the passivation layer has been formed.

### Detailed description of the invention

### Technical Problem

The present invention has been made to solve the problems occurring in the related art, and an object of the present invention is to provide a method of manufacturing a CMOS image sensor, capable of preventing hillock-type defect caused by the delamination of interconnections for a CMOS image sensor.

### Technical Solution

In order to accomplish the object, there is provided a method of manufacturing a CMOS image sensor including the steps of preparing a substrate having a first metal interconnection, forming an interlayer insulation layer over the first metal interconnection, forming a contact hole to expose a part of the first metal interconnection by etching the interlayer layer insulation layer, forming a buffer layer on the interlayer insulation layer and an inner surface of the contact hole, performing an annealing process, forming a spacer on a sidewall of the contact hole by etching the buffer layer, forming a barrier metal layer on a surface of the interlayer insulation layer including the spacer, forming a contact plug on the barrier metal layer such that the contact hole is filled with the contact plug, and forming a second metal interconnection on the interlayer insulation layer such that the second metal interconnection makes contact with the contact plug.

Preferably, the buffer layer includes a nitride layer.

Preferably, the annealing process includes a hydrogen (H₂) annealing process.

Preferably, the annealing process is performed at a temperature of 400°C to 700°C.

Preferably, concentration of H₂ is in a range of 1% to 80% in the hydrogen (H₂) annealing process.

Preferably, the spacer is formed through a dry etching process or a wet etching process.

Preferably, the dry etching process includes an etch back process or a blanket process.

Preferably, the barrier metal layer includes one selected from the group consisting of Ti, TiN, Ta, TaN, AlSiTiN, NiTi, TiBN, ZrBN, TiAlN, TiB₂, Ti/TiN and Ta/TaN.

Preferably, the second metal interconnection includes one selected from the group consisting of Ti/Al/TiN, Ti/Al/Ti/TiN and Ti/TiN/Al/Ti/TiN.

### Advantageous Effects

According to the method of manufacturing the CMOS image sensor of the present invention having the above structure, the annealing process for improving a dark characteristic of a CMOS image sensor is performed using a buffer layer as a protective layer after the contact hole has been formed, so that time for an annealing process performed after a passivation process can be reduced or the annealing process can be omitted. Accordingly, thermal budget can be reduced, so that interconnection delamination can be prevented.

### Description of Drawings

FIG. 1 is a view showing hillock-type defects occurring in a method of manufacturing a CMOS image sensor according to the related art; and
FIGS. 2 to 8 are sectional views showing a method of manufacturing a CMOS image sensor according to an embodiment of the present invention.

### <Description Of Reference Numerals Shown In The Drawings>

100: substrate 102: first metal interconnection
104: interlayer insulation layer 106: contact hole
108: buffer layer 112: barrier metal layer
114: contact plug 116: second metal interconnection

### Mode For Invention

Hereinafter, exemplary embodiments of the present invention will be described with reference to the accompanying drawings. In the drawings, the thickness and the space of layers and regions may be exaggerated to facilitate explanation. When a first layer is referred to as being 'on' or 'above' a second layer or a substrate, it could mean that the first layer is formed directly on the second layer or the substrate, or it could also mean that a third layer may be formed between the first layer and the substrate. Furthermore, the same reference numerals designate the same layers throughout the drawings. In addition, English characters of the reference numerals refer to partial modification of the same layers by an etch process or a polishing process.

### Embodiment

FIGS. 2 to 8 are sectional views showing a method of manufacturing a CMOS image sensor according to an embodiment of the present invention.

As shown in FIG. 2, a first metal interconnection 102 is formed on a substrate 100 including a semiconductor structure including a plurality of transistors and a photodiode serving as a light receiving device. In this case, the first metal interconnection 102 may include one selected from the group consisting of aluminum (Al), copper (Cu), tungsten (W), or platinum (Pt). Preferably, the first metal interconnection 102 includes Al.

Then, an interlayer insulation layer 104 is formed on the substrate 100 to cover the first metal interconnection 102. In this case, the interlayer insulation layer 104 includes an oxide, preferably, a silicon oxide (SiO₂). For example, the interlayer insulation layer 104 may include one selected from the group consisting of a BPSG (BoroPhosphoSilicate Glass) film, a PSG (PhosphoSilicate Glass) film, a BSG (BoroSilicate Glass) film, a USG (Undoped Silicate Glass) film, a PE-TEOS (Plasma Enhanced-Tetra Ethyl Ortho Silicate) film, an HDP (High Density Plasma) film and an FSG (Fluorinated Silicate Glass) film. In addition, the interlayer insulation layer 104 may be formed by coating an SOG (Spin On Glass) based oxide layer. In addition, the film may have a stack structure of at least two layers. For example, if the film has the stack structure, the film includes SOG/PE-TEOS films or FSG/PE-TEOS films.

Subsequently, although not shown, if a step exists in the interlayer insulation layer 104, the interlayer insulation layer 104 may be planarized through a CMP (Chemical Mechanical Polishing) process.

Next, the interlayer insulation layer 104 is etched, thereby forming a contact hole 106 to expose a part of the first metal interconnection 102. The etching process includes a dry etching process or a wet etching process.

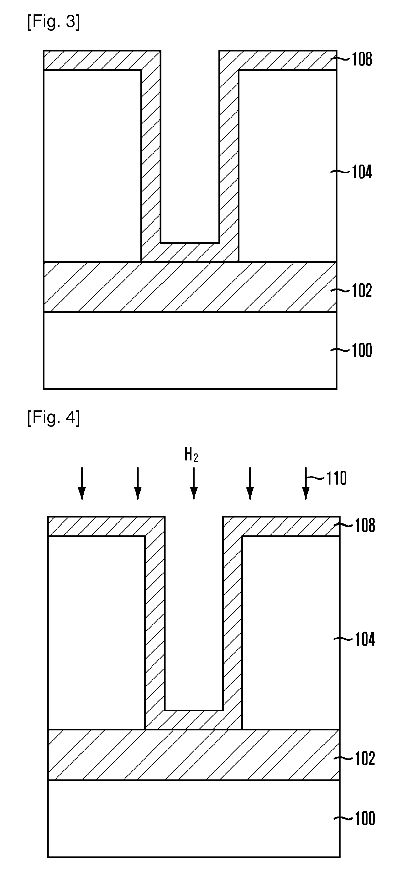

Thereafter, as shown in FIG. 3, a buffer layer 108 is formed on the interlayer insulation layer 104 and an inner surface of the contact hole 106 (see FIG. 2). In this case, the buffer layer 108 may include a nitride layer, preferably, a silicon nitride layer (SiₓN_{y}, x and y are natural numbers). The buffer layer 108 may be formed through one selected from the group consisting of a PECVD (Plasma Enhanced Chemical Vapor Deposition) process, an ALD (Atomic Layer Deposition) process and an MOCVD (Metal Organic CVD) process.

Thereafter, as shown in FIG. 4, a heat treatment process 110 is performed in order to improve a dark characteristic. The heat treatment process 110 includes a hydrogen annealing process, which is performed at the temperature in the range about 400 °C to about 700 °C using the buffer layer 108 as a protective layer. In the hydrogen annealing process, the concentration of H₂ is in the range of 1% to 80%.

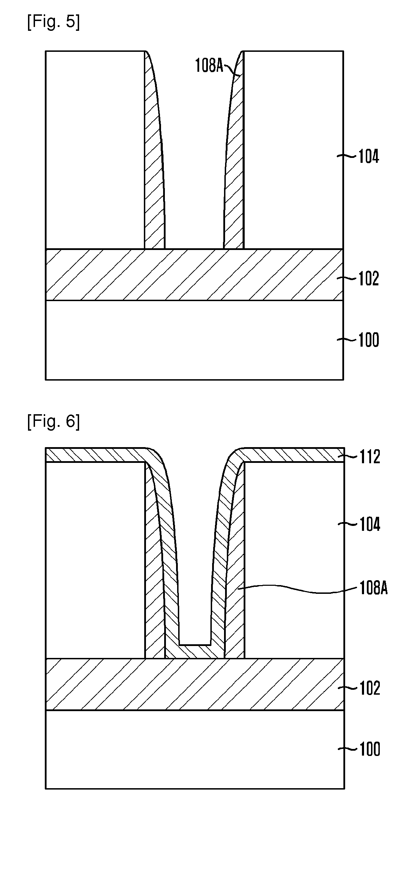

Thereafter, as shown in FIG. 5, spacers 108A are formed on the sidewalls of the contact hole 106 by etching the buffer layer 108. The etching process includes a dry etching process or a wet etching process. The dry etching process may include an etch back process or a blanket process.

Next, as shown in FIG. 6, a barrier metal layer 112 is formed on the spacers 108A, the first metal interconnection 102, and the interlayer insulation layer 104 along the inner surface of the contact hole 106. The barrier metal layer 112 may include one selected from the group consisting of Ti, TiN, Ta, TaN, AlSiTiN, NiTi, TiBN, ZrBN, TiAlN, TiB₂, Ti/TiN and Ta/TaN.

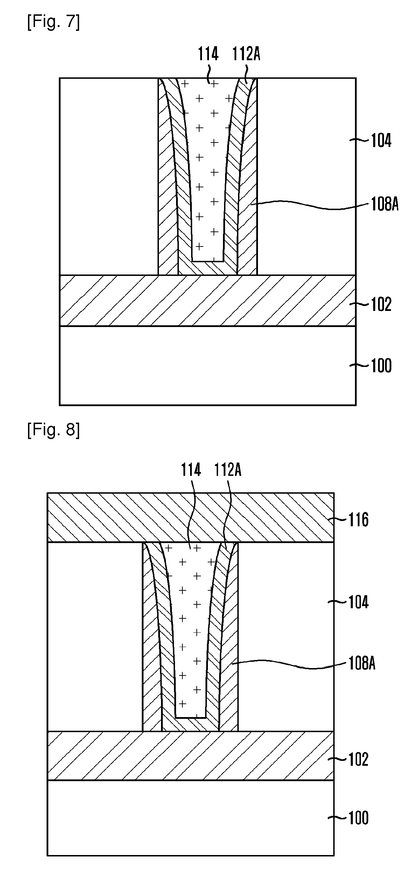

Then, as shown in FIG. 7, after depositing a conductive material for a contact plug on a barrier metal layer 112a such that the contact hole 106 is filled with the conductive material, the resultant structure is planarized through an etch back process or a CMP process, thereby forming a contact plug 114. In this case, the planarization process is performed until a top surface of the interlayer insulation layer 104 is exposed. In other words, when the planarization process is performed, the interlayer insulation layer 104 serves as an etch stop layer or a polish stop layer. In this case, the contact plug 114 includes tungsten (W) or a polycrystalline silicon layer. Preferably, the contact plug 114 includes W.

Then, as shown in FIG. 8, a second metal interconnection 116 is formed on the contact plug 114 and the interlayer insulation layer 104 such that the second metal interconnection 116 makes contact with the contact plug 114. The second metal interconnection 116 may include one selected from the group consisting of a Ti/Al/TiN structure, a Ti/Al/Ti/TiN structure and a Ti/TiN/Al/Ti/TiN structure. In addition, the second metal interconnection 116 may have a barrier metal layer/Al/barrier metal layer structure. In this case, the barrier metal layer may include one selected from the group consisting of Ta, TaN, AlSiTiN, NiTi, TiBN, ZrBN, TiAlN, TiB₂ and Ta/TaN.

Although an exemplary embodiment of the present invention has been described for illustrative purposes, those skilled in the art will appreciate that various modifications, additions and substitutions are possible, without departing from the scope and spirit of the invention as disclosed in the accompanying claims.

## Claims

1. A method of manufacturing a CMOS image sensor, the method comprising the steps of:
preparing a substrate having a first metal interconnection;
forming an interlayer insulation layer on the first metal interconnection;
forming a contact hole to expose a part of the first metal interconnection by etching the interlayer insulation layer;
forming a buffer layer on the interlayer insulation layer and an inner surface of the contact hole;
performing an annealing process;
forming a spacer on the sidewall of the contact hole by etching the buffer layer;
forming a barrier metal layer on a surface of the interlayer insulation layer including the spacer;
forming a contact plug on the barrier metal layer such that the contact hole is filled with the contact plug; and
forming a second metal interconnection on the interlayer insulation layer such that the second metal interconnection makes contact with the contact plug.

2. The method of claim 1, wherein the buffer layer includes a nitride layer.

3. The method of claim 1, wherein the annealing process includes a hydrogen (H₂) annealing process.

4. The method of claim 3, wherein the annealing process is performed at a temperature of 400°C to 700°C.

5. The method of claim 3, wherein concentration of H₂ is in a range of 1% to 80% in the hydrogen (H₂) annealing process.

6. The method of claim 1, wherein the spacer is formed through a dry etching process or a wet etching process.

7. The method of claim 6, wherein the dry etching process includes an etch back process or a blanket process.

8. The method of claim 1, wherein the barrier metal layer includes one selected from the group consisting of Ti, TiN, Ta, TaN, AlSiTiN, NiTi, TiBN, ZrBN, TiAlN, TiB₂, Ti/TiN and Ta/TaN.

9. The method of claim 1, wherein the second metal interconnection includes one selected from the group consisting of Ti/Al/TiN, Ti/Al/Ti/TiN and Ti/TiN/Al/Ti/TiN.
